# EUROPEAN PATENT APPLICATION

(11) **EP 2 779 216 A1**
(43) Date of publication of application: **17.09.2014**
(21) Application number: 12847877.3
(22) Date of filing: 08.11.2012
(51) Int. Cl.: H01L 21/304, B24B 37/00, C09K 3/14

(54) **POLISHING COMPOSITION AND POLISHING METHOD USING SAME, AND SUBSTRATE MANUFACTURING METHOD**

(30) Priority: 08.11.2011 JP 2011244784
(71) Applicant: Fujimi Incorporated, Kiyosu-shi, Aichi 452-8502 (JP)
(72) Inventor: KACHI, Yoshihiro, Kiyosu-shi Aichi 452-8502 (JP); TANAKA, Tomoe, Kiyosu-shi Aichi 452-8502 (JP); UMEDA, Takahiro, Kiyosu-shi Aichi 452-8502 (JP)
(74) Representative: Grünecker, Kinkeldey, Stockmair & Schwanhäusser
(86) International application number: PCT/JP2012/078913
(87) International publication number: WO 2013/069714

(57) **Abstract**

Provided is a polishing composition to be used for polishing an object including a conductor layer and an electrically conductive material layer that is in contact with the conductor layer. In a state in which the positive electrode and the negative electrode of an electrometer are connected to the electrically conductive material layer and the conductor layer, respectively, in the polishing composition at ordinary temperature, the current flowing from the positive electrode to the negative electrode has a positive value or is zero when the electrically conductive material layer and the conductor layer are polished. The polishing composition preferably contains a nitrogen atom-containing compound, a sulfur atom-containing compound, or a phosphorus atom-containing compound as an additive to control the value of the current to positive or zero.

## Description

### TECHNICAL FIELD

The present invention relates to a polishing composition suitable for polishing noble metals and the use thereof.

### BACKGROUND ART

In recent years, novel micromachining techniques have been developed accompanying high integration and high performance of LSIs. Chemical mechanical polishing (hereinafter referred to as "CMP") method is one of those techniques and is often utilized in planarizing an interlayer insulation film, forming a metal plug, and forming embedded wiring (damascene wiring) in an LSI manufacturing process, particularly in a multilayer interconnection forming process. This technique is, for example, disclosed in Patent Document 1. The damascene wiring technique can lead to a simplified wiring process, as well as improved yield and reliability, and thus is expected to expand application thereof.

Currently, with regard to the damascene wiring, copper is primarily used as a wiring metal in high speed logic devices because of its low resistance. In addition, the damascene wiring is also expected to expand its use into memory devices represented by DRAM hereafter. A typical method of metal CMP includes steps of attaching a polishing pad onto a circular polishing platen, moistening the polishing pad surface with a polishing agent, pressing a metal film-formed surface of a substrate against the polishing pad, rotating the polishing platen while applying a predetermined pressure (hereinafter referred to as "polishing pressure") to the substrate from the opposite side to the above surface, thereby removing the metal film at projecting parts by mechanical friction between the polishing agent and the projecting parts of the metal film.

Meanwhile a barrier layer, such as tantalum, a tantalum alloy, and a tantalum compound, is formed below copper or a copper alloy for wiring to prevent diffusion of copper into the interlayer insulation film. Accordingly, it is necessary to remove by CMP an exposed barrier layer except the wiring parts, which are embedded with copper or a copper alloy. The barrier layer conductor film, however, typically has a higher hardness comparing with copper or copper alloys, thus combination of the polishing materials for copper or copper alloys cannot provide a sufficient CMP rate in many cases.

On the other hand, tantalum, tantalum alloys, tantalum compounds and the like used as the barrier layer are chemically stable and are thus difficult to etch and cannot be mechanically polished as easily as copper and copper alloys due to the higher hardness. In addition, ruthenium, ruthenium alloys, and ruthenium compounds have been investigated as a material for the barrier layer in recent years. Ruthenium, ruthenium alloys, and ruthenium compounds have a lower specific resistance than tantalum, tantalum alloys, and tantalum compounds and can be formed into film by chemical vapor deposition (CVD) and are thus excellent regarding the capability of accommodation to narrower line width wiring. Ruthenium, ruthenium alloys, and ruthenium compounds are, however, difficult to be polished due to high chemical stability and hardness thereof similarly to tantalum, tantalum alloys, and tantalum compounds.

A polishing agent used for CMP typically contains an oxidizing agent and abrasive grains. The basic mechanism of CMP with such a polishing agent for CMP is presumed to include first causing a metal film surface to be oxidized by the oxidizing agent and then grinding off the oxidized surface layer with the abrasive grains. The oxidized surface layer of the metal film at recessed parts does not touch the polishing pad so much that a grinding-off effect with the abrasive grains does not reach thereto, and thus the metal film at projecting parts is removed along with progress of CMP to planarize the substrate surface.

A high polishing rate for a wiring metal, stability of the polishing rate, and low defect density on the polished surface are required in CMP. A ruthenium film, however, has higher chemical stability and hardness than other metal films for damascene wiring such as copper or tungsten and is thus difficult to polish. Therefore, the increase in the polishing rate for a ruthenium film results in increased defects on the metal film for damascene wiring. As a polishing liquid for polishing a noble metal film, particularly a ruthenium film, polishing compositions such as those described in Patent Documents 2 and 3, for example, have been proposed. However, further improvement has been required in order to inhibit the defects on the polished surface, particularly corrosive defects, while maintaining the polishing rate.

### PRIOR ART DOCUMENTS

Patent Document 1: U.S. Patent No. 4,944,836
Patent Document 2: Japanese Re-Publication of International Publication No. WO 2007/043517
Patent Document 3: Japanese National Phase Laid-Open Patent Publication No. 2011-503873

### SUMMARY OF THE INVENTION

### Problems that the Invention is to Solve

Accordingly, it is an objective of the present invention to provide a polishing composition capable of inhibiting corrosive defects while maintaining a high polishing rate for an object including a conductor layer and an electrically conductive material layer that is in contact with the conductor layer, particularly for a conductor layer containing a noble metal, and to provide a method for polishing and method for producing a substrate using the polishing composition. Conventionally, corrosive defects in an electrically conductive material have been considered to be caused by a potential difference between the conductor and the electrically conductive material. Namely, it has been considered that when, at a contact surface between two different metals, e.g., an electrically conductive material composed of copper and a barrier conductor containing tantalum, potential of the copper is lower than that of the barrier conductor, electron transfer from the copper surface to the barrier conductor occurs in the vicinity of the boundary between the barrier conductor and the copper to allow copper ions to dissolve into the polishing composition, thereby causing the corrosive defects. Thus, solutions therefor to reduce the potential difference between the conductor and the electrically conductive material have been proposed. In contrast, the present inventors have found that reducing the potential difference between the conductor and the electrically conductive material only is not sufficient enough to inhibit the corrosive defects, and that when electrons transfer from the electrically conductive material to the conductor, i.e., when current flows from the conductor to the electrically conductive material, under specific conditions, the corrosive defects are generated.

### Means for Solving the Problems

The present inventors have found through intensive study that use of a polishing composition exhibiting a positive value (including zero) of current flowing from the conductor to the electrically conductive material under specific conditions enables inhibiting the corrosive defects, while maintaining a high polishing rate for an object including a conductor layer and an electrically conductive material layer that is in contact with the conductor layer, particularly for a conductor layer containing a noble metal. According to the present invention, it is possible to prevent electron transfer from the electrically conductive material to the conductor, i.e., current flow from the conductor to the electrically conductive material, thereby preventing dissolution of electrons and electrically conductive material ions from the surface of the electrically conductive material in the vicinity of the boundary between the conductor and the electrically conductive material into the polishing composition. As a result, the corrosive defects can be prevented.

That is, in accordance with a first aspect of the present invention, provided is a polishing composition to be used for polishing an object including a conductor layer and an electrically conductive material layer that is in contact with the conductor layer. The polishing composition is characterized in that in a state in which a positive electrode and a negative electrode of an electrometer are connected to the electrically conductive material layer and the conductor layer, respectively, in the polishing composition at ordinary temperature, a current flowing from the positive electrode to the negative electrode has a positive value or is zero when the electrically conductive material layer and the conductor layer are polished.

The polishing composition preferably contains an additive to control the value of the current flowing between the conductor and electrically conductive material to positive or zero.

The additive is preferably one or more selected from the group consisting of a nitrogen atom-containing compound, sulfur atom-containing compound, and phosphorus atom-containing compound.

The conductor layer preferably contains a noble metal, in particular ruthenium.

In accordance with a second aspect of the present invention, a method for polishing is provided that includes polishing a surface of an object including a conductor layer and an electrically conductive material layer that is in contact with the conductor layer using the polishing composition according to the first aspect.

In accordance with a third aspect of the present invention, a method for producing a polished substrate is provided. The method includes polishing a surface of a substrate including a conductor layer and an electrically conductive material layer that is in contact with the conductor layer using the polishing composition according to the first aspect, thereby removing a part of the conductor layer and a part of the electrically conductive material layer.

### Effects of the Invention

The present invention succeeds in inhibiting corrosive defects while maintaining a high polishing rate for an object including a conductor layer and an electrically conductive material layer that is in contact with the conductor layer, particularly for a conductor layer containing a noble metal.

### BRIEF DESCRIPTION OF THE DRAWINGS

Fig. 1 is a schematic diagram showing an example of the method for measuring the current value in embodiments of the present invention;
Fig. 2(a) is a scanning electron microscope photograph of a Cu/TEOS patterned wafer surface after polishing, showing an example with no distinct corrosive defects on the surface; and
Fig. 2(b) is also a scanning electron microscope photograph of a Cu/TEOS patterned wafer surface after polishing, showing an example with distinct corrosive defects on the surface.

### MODES FOR CARRYING OUT THE INVENTION

Embodiments of the present invention will be described below.

A polishing composition of the present embodiment is used for polishing an object including a conductor layer and an electrically conductive material layer that is in contact with the conductor layer. Examples of the object to be polished include a substrate used in the wiring part forming process for semiconductor devices, including an interlayer insulation film with recessed parts and projecting parts on the surface thereof, a barrier conductor layer covering the interlayer insulation film along with the surface thereof, and an electrically conductive material layer composed mainly of copper filled in the recessed parts to cover the barrier conductor layer.

Examples of the electrically conductive material include materials composed mainly of metal such as copper, a copper alloy, a copper oxide, a copper alloy oxide, tungsten, a tungsten alloy, silver, a silver alloy, and gold. Above all, electrically conductive materials composed mainly of copper, such as copper, a copper alloy, a copper oxide, and a copper alloy oxide, are preferred and copper is more preferred. Examples of the electrically conductive material layer include a metal layer for wiring part in semiconductor devices.

Examples of the conductor include tungsten, tungsten nitride, a tungsten alloy, other tungsten compound, titanium, titanium nitride, a titanium alloy, other titanium compound, tantalum, tantalum nitride, a tantalum alloy, other tantalum compound, ruthenium, and other ruthenium compound. The conductor layer may be either a layer composed of the conductor or a lamination film including a layer composed of the conductor. Examples of the conductor layer include a barrier conductor layer formed in semiconductor devices in order to prevent diffusion of the electrically conductive material into the interlayer insulation film and to improve adhesiveness between the interlayer insulation film and the electrically conductive material.

When the positive electrode and the negative electrode of an electrometer are connected to the electrically conductive material and the conductor, respectively, in the polishing composition of the present embodiment, the current flowing from the positive electrode to the negative electrode has a positive value or is zero under specific conditions.

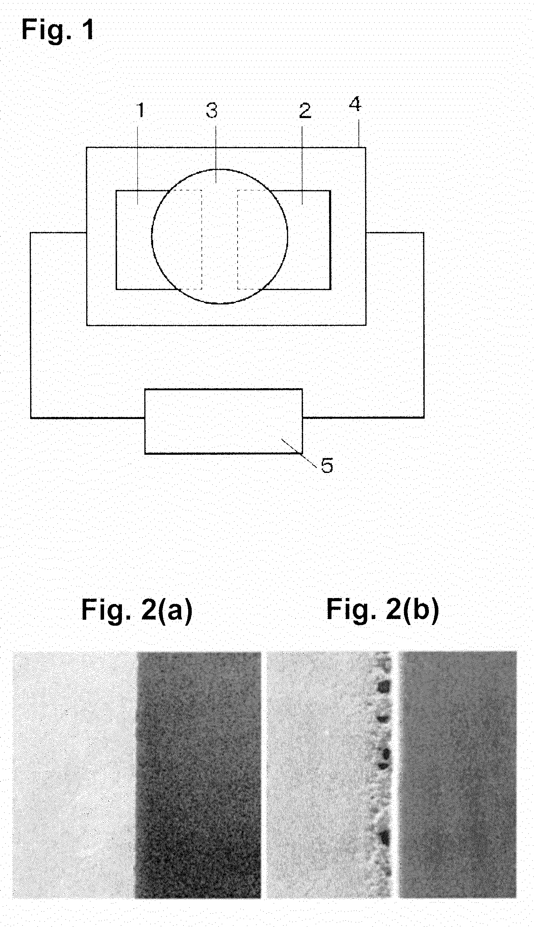

The specific conditions are explained as follows based on Fig. 1, where 1 denotes an electrically conductive material substrate, 2 denotes a conductor substrate, 3 denotes a polishing pad, 4 denotes a container, and 5 denotes an electrometer/ammeter. About 1,000 ml of a polishing composition is first put into a container 4 with a volume of about 2,000 ml and maintained at ordinary temperature. As used herein, the term polishing composition refers to a polishing liquid in which an additive occasionally added immediately before the use for polishing, e.g., a metal-oxidizing agent, has been added. An electrically conductive material substrate 1, in which an electrically conductive material film have been formed on a silicon substrate, and a conductor substrate 2, in which a conductor film such as tantalum have been formed on a silicon substrate, are cut into an appropriate size, and the positive electrode and the negative electrode of an electrometer 5 are connected to the electrically conductive material substrate 1 and the conductor substrate 2, respectively. The electrically conductive material substrate 1 and the conductor substrate 2 are then immersed in the polishing composition while spaced apart and out of contact with each other in a state in which they are parallel with the liquid surface of the polishing composition and both the surface of the electrically conductive material film and the surface of the conductor film face the liquid surface. Then a polishing pad 3 is attached to a rotating body made of a resin (vinyl chloride) that is position-controllable in horizontal and vertical directions and the electrically conductive material substrate 1 and the conductor substrate 2 are polished with this pad. The current value is measured with the electrometer/ammeter 5 from the start of polishing to the lapse of 30 seconds. The container 4 is not particularly limited so long as it is formed with a material nonreactive to the polishing composition, and is preferably made of glass or plastic. As used herein, the term ordinary temperature refers to 5 to 35°C as defined in the Japanese Industrial Standards (JIS) Z8703.

The current value measured with the electrometer/ammeter 5 is preferably zero or more, more preferably 0.001 mA or more, and still more preferably 0.01 mA or more. The larger this current value is, the better the electron transfer from the electrically conductive material to the conductor, i.e., the current flowing from the conductor to the electrically conductive material, can be prevented. Consequently, the corrosive defects can be prevented, thus it is preferable.

Conventionally, corrosive defects in an electrically conductive material have been considered to be caused by a potential difference between the conductor and the electrically conductive material. Namely, it has been considered that when a potential difference is large at a contact surface between two different metals, e.g., an electrically conductive material composed of copper and a barrier conductor containing tantalum, electrons and copper ions dissolve into the polishing composition from the copper surface in the vicinity of the boundary between the barrier conductor and the copper to cause the corrosive defects. Thus, solutions therefor to reduce the potential difference between the conductor and the electrically conductive material have been proposed. In contrast, the present inventors have confirmed that reducing the potential difference between the conductor and the electrically conductive material only is not sufficient enough to inhibit the corrosive defects, and that when electrons transfer from the electrically conductive material to the conductor, i.e., when current flows from the conductor to the electrically conductive material, under the specific conditions, the corrosive defects are generated. Accordingly, the present invention provides a polishing composition exhibiting a positive value (including zero) of current flowing from the conductor to the electrically conductive material under specific conditions. According to the present invention, it is possible to prevent the electron transfer from the electrically conductive material to the conductor, i.e., current flow from the conductor to the electrically conductive material, thereby preventing dissolution of electrons and electrically conductive material ions from the surface of the electrically conductive material in the vicinity of the boundary between the conductor and the electrically conductive material into the polishing composition. As a result, the corrosive defects are considered to be able to be prevented.

The polishing composition of the present embodiment contains an additive to control the value of the current flowing between the conductor and the electrically conductive material to positive or zero. The additive used is selected from materials capable of making the current value flowing between the conductor and the electrically conductive material positive or zero, depending on the type of the conductor, the type of the electrically conductive material, and the pH of the polishing composition. Specifically, the additive is, for example, at least one selected from (A) a nitrogen atom-containing compound, (B) a sulfur atom-containing compound, and (C) a phosphorus atom-containing compound. Among nitrogen atom-containing compounds, benzotriazole, urazole, piperazine, and piperidine are useful as the additive when the conductor layer is a barrier conductor layer containing ruthenium, the electrically conductive material layer contains copper, and the polishing composition has a neutral pH. Among nitrogen atom-containing compounds, ammonia, tetramethylammonium hydroxide, morpholine, 1,2,4-triazole, tetrazole, imidazole, pyrazole, pyridine, pyrimidine, pyrazine, and urazole are useful as the additive when the conductor layer is a barrier conductor layer containing ruthenium, the electrically conductive material layer contains copper, and the polishing composition has an alkaline pH. Sodium sulfate and dimethyl sulfoxide, which are sulfur atom-containing compounds, are useful as the additive when the conductor layer is a barrier conductor layer containing ruthenium, the electrically conductive material layer contains copper, and the polishing composition has an alkaline pH. Among phosphorus atom-containing compounds, phosphoric acid is useful as the additive when the conductor layer is a barrier conductor layer containing ruthenium, the electrically conductive material layer contains copper, and the polishing composition has an acidic or neutral pH. Among phosphorus atom-containing compounds, phosphonic acid is useful as the additive when the conductor layer is a barrier conductor layer containing ruthenium, the electrically conductive material layer contains copper, and the polishing composition has an alkaline pH. Nitrogen atom-containing compounds, sulfur atom-containing compounds, and phosphorus atom-containing compounds may be used by one kind singly or in combination of two or more kinds. In any of those cases, the additive is not particularly limited so long as it is capable of making the current value flowing between the conductor and the electrically conductive material positive or zero.

### (Oxidizing agent)

The polishing composition can optionally contain an oxidizing agent. The oxidizing agent has a function to oxidize the surface of the object to be polished, and addition of the oxidizing agent to the polishing composition leads to an effect to enhance the polishing rate with the polishing composition.

Usable oxidizing agents are, for example, peroxides. Specific examples of the peroxides include hydrogen peroxide, peracetic acid, percarbonates, urea peroxide, and perchloric acid, as well as persulfates, such as sodium persulfate, potassium persulfate, and ammonium persulfate. Above all, persulfates and hydrogen peroxide are preferable from the viewpoint of the polishing rate, and hydrogen peroxide is particularly preferable from the viewpoints of the stability in an aqueous solution and environmental load.

The content of the oxidizing agent in the polishing composition is preferably 10% by mass or more, more preferably 5% by mass or more, and still more preferably 1% by mass or more. As the oxidizing agent content decreases, defects such as dishing on the metal wiring layer can be inhibited.

The content of the oxidizing agent in the polishing composition is also preferably 0.001% by mass or more, more preferably 0.01% by mass or more, and still more preferably 0.1% by mass or more. As the oxidizing agent content increases, the polishing rate is enhanced.

### (Abrasive grains)

The polishing composition can optionally contain abrasive grains. The abrasive grain may be any of inorganic particles, organic particles, and organic-inorganic composite particles. Specific examples of the inorganic particles include particles composed of metal oxides, such as silica, alumina, ceria, and titania, silicon nitride particles, silicon carbide particles, and boron nitride particles. Specific examples of the organic particles include poly(methyl methacrylate) (PMMA) particles. Above all, silica particles are preferable, and colloidal silica is particularly preferable.

The abrasive grains may be surface-modified. Since common colloidal silica without surface modification has a value of zeta potential close to zero under acidic conditions, the silica particles do not electrically repel each other to easily cause aggregation under acidic conditions. On the contrary, abrasive grains which are surface-modified such that the zeta potential has a relatively large positive or negative value even under acidic condition strongly repel each other even under acidic conditions and are satisfactorily dispersed. As a result, the storage stability of the polishing composition is improved. Such surface-modified abrasive grains can be obtained, for example, by mixing a metal such as aluminum, titanium, and zirconium or an oxide thereof with abrasive grains to dope them on the surface of the abrasive grains or by using a silane coupling agent having an amino group to modify the surface of the abrasive grains with a sulfonic acid group or a phosphonic acid group.

The content of the abrasive grains in the polishing composition is preferably 0.1 % by mass or more, more preferably 0.5% by mass or more, and still more preferably 1% by mass or more. As the abrasive grain content increases, there is an advantage of enhancing the removal rate of the object to be polished with the polishing composition.

The content of the abrasive grains in the polishing composition is also preferably 25% by mass or less, more preferably 15% by mass or less, and still more preferably 10% by mass or less. As the abrasive grain content decreases, the material cost of the polishing composition is reduced, and additionally the aggregation of the abrasive grains is less likely to occur. Furthermore, a polished surface with few surface defects is easily obtained by polishing the object to be polished with the polishing composition.

The average primary particle diameter of the abrasive grains is preferably 5 nm or more, more preferably 7 nm or more, and still more preferably 10 nm or more. As the average primary particle diameter of the abrasive grains increases, there is an advantage of enhancing the removal rate of the object to be polished with the polishing composition. The value of the average primary particle diameter of the abrasive grains can be calculated, for example, based on the specific surface area of the abrasive grains measured by the BET method.

The average primary particle diameter of the abrasive grains is also preferably 100 nm or less, more preferably 90 nm or less, and still more preferably 80 nm or less. As the average primary particle diameter of the abrasive grains decreases, a polished surface with few surface defects is easily obtained by polishing the object to be polished with the polishing composition.

The average secondary particle diameter of the abrasive grains is preferably 150 nm or less, more preferably 120 nm or less, and still more preferably 100 nm or less. The value of the average secondary particle diameter of the abrasive grains can be measured, for example, by a laser light scattering method.

The average degree of association of the abrasive grains, obtained by dividing the value of the average secondary particle diameter by the value of the average primary particle diameter, is preferably 1.2 or more, and more preferably 1.5 or more. As the average degree of association of the abrasive grains increases, there is an advantage of enhancing the removing rate of the object to be polished with the polishing composition.

The average degree of association of the abrasive grains is also preferably 4 or less, more preferably 3 or less, and still more preferably 2 or less. As the average degree of association of the abrasive grains decreases, a polished surface with few surface defects is easily obtained by polishing the object to be polished with the polishing composition.

### (Polishing promoter)

The polishing composition can optionally contain a polishing promoter. The complexing agent in the polishing composition has a function to chemically etch the surface of the object to be polished and acts to enhance the polishing rate with the polishing composition.

Usable complexing agents include inorganic acids, organic acids, and amino acids. Specific examples of the inorganic acids include sulfuric acid, nitric acid, boric acid, carbonic acid, hypophosphorous acid, phosphorous acid, and phosphoric acid. Specific examples of the organic acids include formic acid, acetic acid, propionic acid, butyric acid, valeric acid, 2-methylbutyric acid, n-hexanoic acid, 3,3-dimethylbutyric acid, 2-ethylbutyric acid, 4-methylpentanoic acid, n-heptanoic acid, 2-methylhexanoic acid, n-octanoic acid, 2-ethylhexanoic acid, benzoic acid, glycolic acid, salicylic acid, glyceric acid, oxalic acid, malonic acid, succinic acid, glutaric acid, adipic acid, pimelic acid, maleic acid, phthalic acid, malic acid, tartaric acid, citric acid, and lactic acid. Organic sulfuric acids, such as methanesulfonic acid, ethanesulfonic acid, and isethionic acid are also usable. A salt, such as an ammonium salt and an alkali metal salt, of an inorganic acid or an organic acid may be used instead of an inorganic acid or an organic acid or in combination with an inorganic acid or an organic acid. Specific examples of the amino acids include glycine, α-alanine, β-alanine, N-methylglycine, N,N-dimethylglycine, 2-aminobutyric acid, norvaline, valine, leucine, norleucine, isoleucine, phenylalanine, proline, sarcosine, ornithine, lysine, taurine, serine, threonine, homoserine, tyrosine, bicine, tricine, 3,5-diiodo-tyrosine, β-(3,4-dihydroxyphenyl)-alanine, thyroxine, 4-hydroxy-proline, cysteine, methionine, ethionine, lanthionine, cystathionine, cystine, cysteic acid, aspartic acid, glutaminic acid, S-(carboxymethyl)-cysteine, 4-aminobutyric acid, asparagine, glutamine, azaserine, arginine, canavanine, citrulline, δ-hydroxy-lysine, creatine, histidine, 1-methyl-histidine, 3-methyl-histidine, and tryptophan. Above all, glycine, α-alanine, β-alanine, malic acid, tartaric acid, citric acid, a glycolic acid, and isethionic acid, or ammonium salts or alkali metal salts thereof are preferable as a complexing agent from the viewpoint of polishing enhancement.

The upper limit of the polishing promoter content in the polishing composition is not particularly limited, but is preferably 50% by mass, more preferably 10% by mass, and still more preferably 1% by mass. As the polishing promoter content decreases, the surface defects such as dishing can be inhibited.

The lower limit of the polishing promoter content in the polishing composition is also not particularly limited, but is preferably 0.001% by mass, more preferably 0.01% by mass, and still more preferably 0.1% by mass. As the polishing promoter content increases, the polishing rate is enhanced.

### (Metal corrosion inhibitor)

The polishing composition can optionally contain a metal corrosion inhibitor. The addition of the metal corrosion inhibitor to the polishing composition leads to an effect of further decreasing the occurrence of surface defects such as dishing on the surface of the object after polishing with the polishing composition. In addition, when the polishing composition contains an oxidizing agent and/or a complexing agent, the metal corrosion inhibitor relieves the oxidation of the surface of the object to be polished by the oxidizing agent and acts to react with metal ions, which are produced by the oxidation of a metal of the object surface by the oxidizing agent, to form an insoluble complex. As a result, the etching of the surface of the object to be polished by the complexing agent is suppressed, thereby improving flatness of the object after polishing.

The type of the usable metal corrosion inhibitor is not particularly limited, but is preferably a heterocyclic compound. The number of members in the heterocyclic ring in the heterocyclic compound is not particularly limited. The heterocyclic compounds may be a monocyclic compound or a polycyclic compound having a condensed ring.

Specific examples of the heterocyclic compound as the metal corrosion inhibitor include nitrogen-containing heterocyclic compounds, such as pyrrole compounds, pyrazole compounds, imidazole compounds, triazole compounds, tetrazole compounds, pyridine compounds, pyrazine compounds, pyridazine compounds, pyrindine compounds, indolizine compounds, indole compounds, isoindole compounds, indazole compounds, purine compounds, quinolizine compounds, quinoline compounds, isoquinoline compounds, naphthyridine compounds, phthalazine compounds, quinoxaline compounds, quinazoline compounds, cinnoline compounds, buterizine compounds, thiazole compounds, isothiazole compounds, oxazole compounds, isoxazole compounds, and furazan compounds. Specific examples of the pyrazole compounds include 1 H-pyrazole, 4-nitro-3-pyrazolecarboxylic acid, and 3,5-pyrazolecarboxylic acid. Specific examples of the imidazole compounds include imidazole, 1-methylimidazole, 2-methylimidazole, 4-methylimidazole, 1,2-dimethylpyrazole, 2-ethyl-4-methylimidazole, 2-isopropylimidazole, benzimidazole, 5,6-dimethylbenzimidazole, 2-aminobenzimidazole, 2-chlorobenzimidazole, and 2-methylbenzimidazole. Specific examples of the triazole compounds include 1,2,3-triazole, 1,2,4-triazole, 1-methyl-1,2,4-triazole, methyl-1H-1,2,4-triazole-3-carboxylate, 1,2,4-triazole-3-carboxylic acid, 1,2,4-triazole-3-methyl carboxylate, 3-amino-1H-1,2,4-triazole, 3-amino-5-benzyl-4H-1,2,4-triazole, 3-amino-5-methyl-4H-1,2,4-triazole, 3-nitro-1,2,4-triazole, 3-bromo-5-nitro-1,2,4-triazole, 4-(1,2,4-triazole-1-yl)phenol, 4-amino-1,2,4-triazole, 4-amino-3,5-dipropyl-4H-1,2,4-triazole, 4-amino-3,5-dimethyl-4H-1,2,4-triazole, 4-amino-3,5-diheptyl-4H-1,2,4-triazole, 5-methyl-1,2,4-triazole-3,4-diamine, 1-hydroxybenzotriazole, 1-aminobenzotriazole, 1-carboxybenzotriazole, 5-chloro-1H-benzotriazole, 5-nitro-1H-benzotriazole, 5-carboxy-1H-benzotriazole, 5,6-dimethyl-1H-benzotriazole, and 1-(1",2'-dicarboxyethyl)benzotriazole. Specific examples of the tetrazole compounds include 1 H-tetrazole, 5-methyltetrazole, 5-aminotetrazole, and 5-phenyltetrazole. Specific examples of the indole compounds include 1H-indole, 1-methyl-1H-indole, 2-methyl-1H-indole, 3-methyl-1H-indole, 4-methyl-1H-indole, 5-methyl-1H-indole, 6-methyl-1 H-indole, and 7-methyl-1 H-indole. Specific examples of the indazole compounds include 1 H-indazole and 5-amino-1H-indazole. The metal corrosion inhibitor is preferably a heterocyclic compound having a triazole skeleton, and above all, 1,2,3-triazole and 1,2,4-triazole are particularly preferable. Since these heterocyclic compounds have high chemical or physical adsorbability to the surface of the object to be polished, a stronger protective film is formed on the surface of the object to be polished. This leads to capability of inhibiting excessive etching of the surface of the object after polishing with the polishing composition. Consequently, excessive polishing can be inhibited.

The upper limit of the metal corrosion inhibitor content in the polishing composition is not particularly limited, but is preferably 50% by mass, more preferably 10% by mass, and still more preferably 1% by mass. As the metal corrosion inhibitor content decreases, the polishing rate is enhanced.

The lower limit of the metal corrosion inhibitor content in the polishing composition is also not particularly limited, but is preferably 0.001% by mass, more preferably 0.01% by mass, and still more preferably 0.1% by mass. As the metal corrosion inhibitor content increases, the surface defects such as dishing can be inhibited.

### (pH of polishing composition and pH adjusting agent)

The upper limit of the pH of the polishing composition is not particularly limited, but is preferably 12, more preferably 11, and still more preferably 10. The lower limit of the pH of the polishing composition is also not particularly limited, but is preferably 2, more preferably 3, and still more preferably 4. When the pH of the polishing composition is within the range described above, an effect of inhibiting excessive etching of the surface of the object to be polished is obtained, thus results in inhibiting excessive polishing and corrosion.

A pH adjusting agent may be used in order to adjust the pH of the polishing composition at a desired value as necessary. The pH adjusting agent may be either an acid or an alkali and either an inorganic or organic compound. The pH adjusting agent may be suitably selected such that the effect to enhance the polishing rate by the polishing composition of the present embodiment is not impaired.

According to the present embodiment, the following operation and advantages are obtained.

According to the polishing composition of the present embodiment to be used for polishing an object including a conductor layer and an electrically conductive material layer that is in contact with the conductor layer, in a state in which the positive electrode and the negative electrode of an electrometer are connected to the electrically conductive material layer and the conductor layer, respectively, in the polishing composition at ordinary temperature, the current flowing from the positive electrode to the negative electrode has a positive value or is zero when both surfaces of the electrically conductive material (positive electrode) and conductor (negative electrode) are polished. Thus, it is possible to prevent electron transfer from the electrically conductive material to the conductor, i.e., to prevent current flowing from the conductor to the electrically conductive material, thereby preventing dissolution of electrons and the electrically conductive material ions from the surface of the electrically conductive material in the vicinity of the boundary between the conductor and the electrically conductive material into the polishing composition. As a result, the corrosive defects are considered to be able to be prevented.

The polishing composition of the present embodiment can contain an additive to control the value of the current flowing between the conductor and the electrically conductive material to positive or zero, as well as abrasive grains, an oxidizing agent, a complexing agent, and a metal corrosion inhibitor. The additives used here are not limited so long as when the positive electrode and the negative electrode of an electrometer are connected to the electrically conductive material layer and the conductor layer, respectively, in the polishing composition, the current flowing from the positive electrode to the negative electrode has a positive value or is zero under the specific conditions.

The embodiment described above may be modified as follows.
- The polishing composition of the embodiment described above may further contain a known additive such as a surfactant, a water-soluble polymer, and a preservative, as necessary. The known additive used here are not limited so long as when the positive electrode and the negative electrode of an electrometer are connected to the electrically conductive material layer and the conductor layer, respectively, in the polishing composition, the current flowing from the positive electrode to the negative electrode has a positive value or is zero under the specific conditions.
- The polishing composition of the embodiment described above may be of a one-pack type or may be of a multi-pack type, such as a two-pack type.
- The polishing composition of the embodiment described above may be prepared by diluting an undiluted solution of the polishing composition with water.

Next, examples of the present invention and comparative examples will be described.

Components were mixed so as to form each composition shown in Tables 1 to 3, whereby the polishing compositions of Examples 1 to 26 and Comparative Examples 1 to 78 were prepared. The abrasive grain content in each polishing composition is shown in the column entitled "Content (% by mass)" in the column entitled "Abrasive grains" of Tables 1 to 3. The abrasive grains used in each polishing composition was colloidal silica having an average primary particle diameter of 35 nm, an average secondary particle diameter of about 70 nm, and an average degree of association of 2.

The type and content of the additive contained in each polishing composition to control the value of the current flowing between the conductor and the electrically conductive material to positive are shown in the columns entitled "Type" and "Content (% by mass)", respectively, in the column entitled "Additive to control value of current flowing between conductor and electrically conductive material to positive" of Tables 1 to 3.

The pH of each polishing composition is shown in the column entitled "pH" of Tables 1 to 3. The pH was adjusted to the predetermined value with an inorganic acid or inorganic base added. In addition, hydrogen peroxide was added to each polishing composition so as to make the content thereof in the polishing composition 2% by mass immediately before the use for polishing.

The potential difference and current value between the conductor and the electrically conductive material were measured using each polishing composition of Examples 1 to 26 and Comparative Examples 1 to 78 in a manner described below. About 1,000 ml of each polishing composition was first put into a plastic container with a volume of about 2,000 ml and maintained at 25 ± 3°C (ordinary temperature). An electrically conductive substrate having an electrically conductive material film composed of copper formed on a silicon substrate by a sputtering method and a conductor substrate having a conductor film composed of ruthenium formed on a silicon substrate by a sputtering method are cut into an appropriate size, and the positive electrode and the negative electrode of an electrometer are connected to the electrically conductive material substrate and the conductor substrate, respectively. The electrically conductive material substrate and the conductor substrate were then immersed in the polishing composition while spaced apart and out of contact with each other in a state in which they are parallel with the liquid surface of the polishing composition and both the surface of the electrically conductive material film and the surface of the conductor film face the liquid surface. Then a polishing pad was attached to a rotating body made of a vinyl chloride resin that was position-controllable in horizontal and vertical directions and the electrically conductive material substrate and the conductor substrate were polished with this pad. The potential difference and current value were measured from the start of polishing to the lapse of 30 seconds. The results are shown in the columns entitled "Potential difference" and "Current value", respectively, of Tables 1 to 3. The values in the column entitled "Current value" are those rounded off the fourth decimal place.

Subsequently, a Cu wired (electrically conductive material) wafer including a conductor film composed of ruthenium and an insulation film composed of TEOS was polished using each polishing composition of Examples 1 to 26 and Comparative Examples 1 to 78 under the conditions shown in Table 4. By using a scanning electron microscope, the wafer was evaluated for the corrosive defects on the electrically conductive material surface after polishing under the conditions shown in Table 4 for a fixed time. The results are shown in the column entitled "Corrosive defects" in the column entitled "Evaluation" of Tables 1 to 3. In the column entitled "Corrosive defects", "○" represents the case where no corrosive defects were found as shown in Fig. 2(a) and "×" represents the case where corrosive defects were found as shown in Figure 2(b).

**Table 1**

| | Abrasive grains | Additive to control value of current flowing between conductor and electrically conductive material to positive | | pH | Potential difference | Current value | Evaluation |
|---|---|---|---|---|---|---|---|
| | Content (%by mass) | Type | Content (% by mass) | | (mV) | (mA) | Corrosive defects |
| Comparative Example 1 | 10 | Sodium sulfate | 1.7 | 3 | 435.7 | -1.875 | × |
| Comparative Example 2 | 10 | Potassium sulfite | 1.9 | 3 | 171.7 | -0.049 | × |
| Comparative Example 3 | 10 | Sodium allylsulfonate | 1.7 | 3 | 475.3 | -0.023 | × |
| Comparative Example 4 | 10 | Dimethyl sulfoxide | 0.93 | 3 | 138.1 | -0.141 | × |
| Comparative Example 5 | 10 | Sodium metabisulfite | 2.3 | 3 | 199.6 | -0.411 | × |
| Comparative Example 6 | 10 | Sodium thiosulfate | 0.91 | 3 | 396.5 | -4.033 | × |
| Comparative Example 7 | 10 | Sodium dithionite | 2.1 | 3 | 317.5 | -1.292 | × |
| Comparative Example 8 | 10 | Thiourea | 0.91 | 3 | 612.4 | -3.417 | × |
| Comparative Example 9 | 10 | Ammonium thiocyanate | 0.91 | 3 | 400.6 | -0.763 | × |
| Example 1 | 10 | Phosphoric acid | 1.2 | 3 | 399.4 | 2.800 | ○ |
| Comparative Example 10 | 10 | Triammonium phosphate trihydrate | 2.4 | 3 | 305.7 | -2.983 | × |
| Comparative Example 11 | 10 | Phosphonic acid | 0.98 | 3 | 313.0 | -2.550 | × |
| Comparative Example 12 | 10 | Diphosphoric acid | 2.1 | 3 | 484.5 | -3.525 | × |
| Comparative Example 13 | 10 | Phytic acid | 7.9 | 3 | 478.6 | -2.917 | × |
| Comparative Example 14 | 10 | Dipotassium phosphonate | 1.4 | 3 | 315.1 | -2.875 | × |
| Comparative Example 15 | 10 | 1,2,3-Triazole | 0.83 | 3 | 180.0 | -0.743 | × |
| Comparative Example 16 | 10 | 1,2,4-triazole | 0.83 | 3 | 245.2 | -1.013 | × |
| Comparative Example 17 | 10 | Benzotriazole | 1.4 | 3 | 374.5 | -0.096 | × |
| Comparative Example 18 | 10 | Tetrazole | 0.84 | 3 | -12.1 | -0.148 | × |
| Comparative Example 19 | 10 | Imidazole | 0.82 | 3 | 393.7 | -0.604 | × |
| Comparative Example 20 | 10 | Benzimidazole | 1.4 | 3 | -14.3 | -1.140 | × |
| Comparative Example 21 | 10 | Pyrazole | 0.82 | 3 | 447.3 | -0.638 | × |
| Comparative Example 22 | 10 | Pyridine | 0.95 | 3 | 424.6 | -1.415 | × |
| Comparative Example 23 | 10 | Pyrimidine | 0.96 | 3 | 397.5 | -1.010 | × |
| Example 2 | 10 | Pyrazine | 0.96 | 3 | 327.5 | 0.000 | ○ |
| Comparative Example 24 | 10 | 1,10-Phenanthroline monohydrate | 2.1 | 3 | 218.8 | -0.858 | × |
| Comparative Example 25 | 10 | 2,2'-Bipyridyl | 1.9 | 3 | 479.4 | -1.658 | × |
| Example 3 | 10 | Urazole | 1.2 | 3 | 361.0 | 0.000 | ○ |
| Example 4 | 10 | Acetylacetone | 1.2 | 3 | 442.1 | 0.000 | ○ |
| Comparative Example 26 | 10 | Tetramethylammonium hydroxide | 1.1 | 3 | 359.8 | -0.718 | × |
| Comparative Example 27 | 10 | Piperazine | 1.0 | 3 | 396.1 | -0.001 | × |
| Comparative Example 28 | 10 | Triethanolamine | 1.8 | 3 | 251.4 | -0.158 | × |
| Comparative Example 29 | 10 | Morpholine | 1.0 | 3 | 306.7 | -0.572 | × |
| Comparative Example 30 | 10 | Piperidine | 1.0 | 3 | 251.1 | -0.031 | × |
| Comparative Example 31 | 10 | Urea | 0.72 | 3 | 322.4 | -0.614 | × |

**Table 2**

| | Abrasive grains | Additive to control value of current flowing between conductor and electrically conductive material to positive | | pH | Potential difference | Current value | Evacuation |
|---|---|---|---|---|---|---|---|
| | Content (% by mass) | Type | Content (% by mass) | | (mV) | (mA) | Corrosive defects |
| Comparative Example 32 | 10 | Sodium sulfate | 1.7 | 7 | 103.4 | -0.058 | × |
| Comparative Example 33 | 10 | Potassium sulfite | 1.9 | 7 | 105.8 | -0.128 | × |
| Comparative Example 34 | 10 | Sodium allylsulfonate | 1.7 | 7 | 192.4 | -0.078 | × |
| Comparative Example 35 | 10 | Dimethyl sulfoxide | 0.93 | 7 | 363.7 | -0.152 | × |
| Comparative Example 36 | 10 | Sodium metabisulfite | 2.3 | 7 | 346.7 | -1.742 | × |
| Comparative Example 37 | 10 | Sodium thiosulfate | 0.91 | 7 | 380.8 | -3.433 | × |
| Comparative Example 38 | 10 | Sodium dithionite | 2.1 | 7 | -54.8 | -7.592 | × |
| Comparative Example 39 | 10 | Thiourea | 0.91 | 7 | 435.8 | -2.508 | × |
| Comparative Example 40 | 10 | Ammonium thiocyanate | 0.91 | 7 | 333.8 | -1.075 | × |
| Example 5 | 10 | Phosphoric acid | 1.2 | 7 | 229.6 | 0.665 | ○ |
| Comparative Example 41 | 10 | Triammonium phosphate trihydrate | 2.4 | 7 | 167.9 | -0.087 | × |
| Comparative Example 42 | 10 | Phosphonic acid | 0.98 | 7 | 211.1 | -0.086 | × |
| Comparative Example 43 | 10 | Diphosphoric acid | 2.1 | 7 | 366.3 | -3.033 | × |
| Comparative Example 44 | 10 | Phytic acid | 7.9 | 7 | 244.8 | -0.541 | × |
| Comparative Example 45 | 10 | Dipotassium phosphonate | 1.4 | 7 | 191.9 | -0.081 | × |
| Comparative Example 46 | 10 | 1,2,3-Triazole | 0.83 | 7 | 300.0 | -0.336 | × |
| Comparative Example 47 | 10 | 1,2,4-triazole | 0.83 | 7 | 121.3 | -0.028 | × |
| Example 6 | 10 | Benzotriazole | 1.4 | 7 | -20.0 | 0.009 | ○ |
| Comparative Example 48 | 10 | Tetrazole | 0.84 | 7 | 293.5 | -0.027 | × |
| Comparative Example 49 | 10 | Imidazole | 0.82 | 7 | 300.6 | -0.134 | × |
| Comparative Example 50 | 10 | Benzimidazole | 1.4 | 7 | 270.3 | -0.087 | × |
| Comparative Example 51 | 10 | Pyrazole | 0.82 | 7 | 375.4 | -0.086 | × |
| Example 7 | 10 | Pyridine | 0.95 | 7 | 212.9 | 0.000 | ○ |
| Example 8 | 10 | Pyrimidine | 0.96 | 7 | 140.6 | 0.000 | ○ |
| Example 9 | 10 | Pyrazine | 0.96 | 7 | 89.8 | 0.000 | ○ |
| Comparative Example 52 | 10 | 2,2'-Bipyridyl | 1.9 | 7 | 436.3 | -0.707 | × |
| Example 10 | 10 | Urazole | 1.2 | 7 | 138.4 | 0.037 | ○ |
| Comparative Example 53 | 10 | Acetylacetone | 1.2 | 7 | 331.7 | -0.311 | × |
| Comparative Example 54 | 10 | Tetramethylammonium hydroxide | 1.1 | 7 | 50.7 | -0.028 | × |
| Example 11 | 10 | Piperazine | 1.0 | 7 | 57.9 | 0.000 | ○ |
| Comparative Example 55 | 10 | Triethanolamine | 1.8 | 7 | 222.8 | -0.193 | × |
| Comparative Example 56 | 10 | Morpholine | 1.0 | 7 | 84.6 | -0.056 | × |
| Example 12 | 10 | Piperidine | 1.0 | 7 | 123.2 | 0.014 | ○ |
| Comparative Example 57 | 10 | Urea | 0.72 | 7 | 206.9 | -0.017 | × |

**Table 3**

| | Abrasive grains | Additive to control value of current flowing between conductor and electrically conductive material to positive | | pH | Potential difference | Current value | Evaluation |
|---|---|---|---|---|---|---|---|
| | Content (% by mass) | Type | Content (% by mass) | | (mV) | (mA) | Corrosive defects |
| Example 13 | 10 | Sodium sulfate | 1.7 | 10 | 1.6 | 0.171 | ○ |
| Comparative Example 58 | 10 | Potassium sulfite | 1.9 | 10 | 115.3 | -0.021 | × |
| Comparative Example 59 | 10 | Sodium allylsulfonate | 1.7 | 10 | 204.7 | -0.248 | × |
| Example 14 | 10 | Dimethyl sulfoxide | 0.93 | 10 | -254.7 | 0.096 | ○ |
| Comparative Example 60 | 10 | Sodium metabisulfite | 2.3 | 10 | 365.8 | -1.492 | × |
| Comparative Example 61 | 10 | Sodium thiosulfate | 0.91 | 10 | 315.8 | -2.967 | × |
| Comparative Example 62 | 10 | Sodium dithionite | 2.1 | 10 | -1.1 | -0.122 | × |
| Comparative Example 63 | 10 | Thiourea | 0.91 | 10 | 338.6 | -0.830 | × |
| Comparative Example 64 | 10 | Ammonium thiocyanate | 0.91 | 10 | 233.6 | -0.103 | × |
| Comparative Example 65 | 10 | Phosphoric acid | 1.2 | 10 | 307.3 | -0.046 | × |
| Comparative Example 66 | 10 | Triammonium phosphate trihydrate | 2.4 | 10 | 320.4 | -1.125 | × |
| Example 15 | 10 | Phosphonic acid | 0.98 | 10 | -7.4 | 0.285 | ○ |
| Comparative Example 67 | 10 | Diphosphoric acid | 2.1 | 10 | 254.9 | -0.530 | × |
| Comparative Example 68 | 10 | Phytic acid | 7.9 | 10 | 124.8 | -0.133 | × |
| Comparative Example 69 | 10 | Dipotassium phosphonate | 1.4 | 10 | 38.5 | -0.137 | × |
| Comparative Example 70 | 10 | 1,2,3-Triazole | 0.83 | 10 | 310.0 | -0.152 | × |
| Example 16 | 10 | 1,2,4-triazole | 0.83 | 10 | 76.6 | 0.058 | ○ |
| Comparative Example 71 | 10 | Benzotriazole | 1.4 | 10 | 17.9 | -0.023 | × |
| Example 17 | 10 | Tetrazole | 0.84 | 10 | -27.7 | 0.083 | ○ |
| Example 18 | 10 | Imidazole | 0.82 | 10 | 196.4 | 0.113 | ○ |
| Comparative Example 72 | 10 | Benzimidazole | 1.4 | 10 | 133.2 | -0.207 | × |
| Example 19 | 10 | Pyrazole | 0.82 | 10 | 112.6 | 0.053 | ○ |
| Example 20 | 10 | Pyridine | 0.95 | 10 | 185.3 | 0.000 | ○ |
| Example 21 | 10 | Pyrimidine | 0.96 | 10 | 194.2 | 0.201 | ○ |
| Example 22 | 10 | Pyrazine | 0.96 | 10 | 155.6 | 0.057 | ○ |
| Comparative Example 73 | 10 | 2,2'-Bipyridyl | 1.9 | 10 | 133.9 | -0.319 | × |
| Example 23 | 10 | Urazole | 1.2 | 10 | 49.7 | 0.161 | ○ |
| Comparative Example 74 | 10 | Acetylacetone | 1.2 | 10 | 192.8 | -0.051 | × |
| Example 24 | 10 | Ammonia | 0.2 | 10 | -190.1 | 0.025 | ○ |
| Example 25 | 10 | Tetramethylammonium hydroxide | 1.1 | 10 | 45.7 | 0.073 | ○ |
| Comparative Example 75 | 10 | Piperazine | 1.0 | 10 | 92.3 | -0.153 | × |
| Comparative Example 76 | 10 | Triethanolamine | 1.8 | 10 | 160.8 | -0.453 | × |
| Example 26 | 10 | Morpholine | 1.0 | 10 | 44.0 | 0.027 | ○ |
| Comparative Example 77 | 10 | Piperidine | 1.0 | 10 | 51.5 | -0.063 | × |
| Comparative Example 78 | 10 | Urea | 0.72 | 10 | 50.1 | -0.126 | × |

**Table 4**

| |
|---|
| Polisher: One-side CMP polishing apparatus |
| Polishing pad: Polishing pad made of polyurethane |
| Polishing pressure: 2.0 psi (≈ 138 hPa) |
| Polishing composition: Batch use |
| Speed of rotation: 60 rpm |

As shown in Tables 1 to 3, it was observed that in the case where the polishing compositions of Examples 1 to 26 were used, there is a significantly excellent effect for inhibiting corrosive defects when compared with the case where the polishing compositions of Comparative Examples 1 to 78, which are not correspondent with those of the present invention, were used.

## Claims

1. A polishing composition to be used for polishing an object including a conductor layer and an electrically conductive material layer that is in contact with the conductor layer, the polishing composition being **characterized in that**
in a state in which a positive electrode and a negative electrode of an electrometer are connected to the electrically conductive material layer and the conductor layer, respectively, in the polishing composition at ordinary temperature, a current flowing from the positive electrode to the negative electrode has a positive value or is zero when the electrically conductive material layer and the conductor layer are polished.

2. The polishing composition according to claim 1, comprising an additive to control the value of the current to positive or zero.

3. The polishing composition according to claim 2, wherein the additive is one or more selected from the group consisting of a nitrogen atom-containing compound, a sulfur atom-containing compound, and a phosphorus atom-containing compound.

4. The polishing composition according to any one of claims 1 to 3, wherein the conductor layer contains a noble metal.

5. The polishing composition according to any one of claims 1 to 4, wherein the conductor layer contains ruthenium.

6. A method for polishing comprising polishing a surface of an object including a conductor layer and an electrically conductive material layer that is in contact with the conductor layer using the polishing composition according to any one of claims 1 to 5.

7. A method for producing a polished substrate comprising polishing a surface of a substrate including a conductor layer and an electrically conductive material layer that is in contact with the conductor layer using the polishing composition according to any one of claims 1 to 5, thereby removing a part of the conductor layer and a part of the electrically conductive material layer.
